# NEUE EUROPÄISCHE PATENTSCHRIFT

(11) **EP 2 520 142 B2**
(45) Veröffentlichungstag und Bekanntmachung des Hinweises auf die Entscheidung über den Einspruch: **23.03.2022**
(45) Hinweis auf die Patenterteilung: 26.11.2014
(21) Anmeldenummer: 10792819.4
(22) Anmeldetag: 27.11.2010
(51) Int. Cl.: H05K 5/06, G01D 11/24, H03K 17/95

(54) **SENSOR MIT GEHÄUSE UND VERFAHREN ZU DESSEN HERSTELLUNG**
SENSOR WITH A HOUSING, AND METHOD FOR THE PRODUCTION THEREOF
CAPTEUR DOTÉ D'UN BOÎTIER ET PROCÉDÉ DE FABRICATION CORRESPONDANT

(30) Priorität: 30.12.2009 DE 102009060872
(43) Veröffentlichungstag der Anmeldung: 07.11.2012
(73) Patentinhaber: Baumer Innotec AG, 8500 Frauenfeld (CH)
(72) Erfinder: WEHRLE, Wolfgang, 78467 Konstanz (DE); JÜRGENS, Alexander, CH-8500 Frauenfeld (CH)
(74) Vertreter: Strauss, Steffen
(86) Internationale Anmeldenummer: PCT/EP2010/007211
(87) Internationale Veröffentlichungsnummer: WO 2011/079896

(56) Entgegenhaltungen:
- EP-A2- 2 101 554
- EP-A2- 2 101 554
- JP-A- 8 235 985
- US-A1- 2009 203 269
- US-A1- 2009 211 357
- US-A1- 2009 211 357

## Beschreibung

Die vorliegende Erfindung betrifft einen gehäusten Sensor, sowie ein Verfahren zum Verkapseln eines Sensors in einem Gehäuse. Insbesondere betrifft die Erfindung die hermetische Verkapselung von Sensorplatinen.

Aus der DE 44 47 513 A1 ist ein wasserdichtes Gehäuse zum Schutz von Elektronikschaltkreisen für Sensoren, beispielsweise Drucksensoren bekannt. Das Gehäuse ist zweiteilig ausgebildet. Zur Montage wird die Sensorplatine in eine erste Gehäusehälfte eingesetzt, wo die Sensorplatine auf Plattenlagern aufliegt. Die zweite Gehäusehälfte weist Federelemente auf, mit welcher die Sensorplatine beim Zusammenfügen der Gehäusehälften gegen die Plattenlager gepresst und so in ihrer Lage relativ zum Gehäuse fixiert wird. Die Gehäusehälfte mit den Plattenlagern weist einen ausgeformten Steckerkörper auf, in welchem Kontaktstifte verlaufen, welche durch die Wandung der Gehäusehälfte durchgeführt sind. Die innenseitigen Enden der Kontaktstifte sind in zusammengesetztem Zustand durch Bohrungen durch die Platine geführt. Da das Steckerelement als Ausformung des Gehäuses ausgebildet ist, ist die Anschlusskonfiguration entsprechend festgelegt. Werden verschiedene Anschlußkonfigurationen benötigt, so müssten entsprechend verschiedene Gehäuse-Formteile bereitgehalten werden.

In der JP 08-235985 A ist ein luftdicht abgeschlossener elektronischer Sensor, im Speziellen ein kapazitiver Näherungssensor beschrieben. Eine Leiterplatte ist über Stifte mit einem Sensorkopf verbunden. Die mit der Sensorelektronik bestückte Leiterplatte und der Sensorkopf sind in ein becherförmiges Metallgehäuse eingesetzt. An der Stirnseite ist Buchse mit einer Öffnung angeordnet, durch welche ein Kabel hindurchgeführt und abgedichtet wird. Über das Gehäuse wird ein weiteres Gehäuse gestülpt, welches die gegenüberliegende Seite des Metallgehäuses, an welcher der Sensorkopf angeordnet ist, abdichtet. Der Anschluss des Kabels erfordert eine Kontaktierung der Platine nach der Durchführung durch die Buchse.

In der US 2009/0203269 ist ein hermetisch verkapselter Näherungssensor offenbart.

Aus der DE 10 2004 011 804 A1 ist ein gehäuster optischer Sensor bekannt, dessen Stecker oder Kabel und dessen Deckel durch einen Niederdruckspritzvorgang fixiert, verschlossen und abgedichtet sind.

Der Erfindung liegt die Aufgabe zugrunde, die Verkapselung von Sensoren dahingehend zu verbessern, dass die Montage des Sensors im Gehäuse und dessen Kontaktierung einerseits vereinfacht und andererseits modularisiert wird.

Zur Lösung dieser Aufgabe wird erfindungsgemäß ein Verfahren zur hermetischen Verkapselung eines Sensors in einem Gehäuse vorgeschlagen, wobei der Sensor zumindest ein Sensorelement zur Erfassung einer physikalischen Größe umfasst, und das Sensorelement an eine elektronische Schaltung auf einer Leiterplatte angeschlossen ist, wobei auf der Leiterplatte Leiterbahnen vorgesehen sind, welche Anschlusselemente für die elektronische Schaltung bilden, und wobei die Leiterplatte einen an einer Kante der Leiterplatte angrenzenden Kontaktierungsabschnitt, sowie einen Bestückungsabschnitt aufweist, welcher mit den elektronischen Bauelementen der Schaltung des Sensors bestückt ist, wobei die Leiterbahnen vom Bestückungsabschnitt zum Kontaktierungsabschnitt hin verlaufen, so dass sie jeweils auf der Leiterplattenseite, auf der die Leiterbahn verläuft, am Kontaktierungsabschnitt kontaktierbar sind,
- wobei die Platine, beziehungsweise Leiterplatte in ein Gehäuse eingesetzt wird, welches die Seiten der Leiterplatte umgibt, und wobei das Gehäuse eine Anschlußseite aufweist, und wobei im Gehäuse an der Anschlußseite eine gegenüber dem Gehäuseende zurückgesetzte Trennwand angeordnet ist, welche den Raum des Sensorgehäuses in einen Anschlußteil und einen in Richtung auf die Anschlußseite gesehen hinter der Trennwand liegenden Sensorteil unterteilt, wobei
- die Trennwand einen Schlitz aufweist, und wobei
- die Leiterplatte so eingesetzt wird, dass deren Bestückungsabschnitt im Sensorteil des Gehäuses angeordnet ist und deren Anschlussabschnitt und die darauf verlaufenden Leiterbahnen durch den Schlitz in den Anschlussteil des Sensorgehäuses hineinragen, und die Leiterplatte in dieser Position fixiert wird, und wobei
- ein elektrisches Anschlusselement an der Anschlussseite befestigt und mit den Leiterbahnen auf dem Kontaktierungsabschnitt elektrisch verbunden wird, und
- am Anschlussteil des Gehäuses oder an der Trennwand der Sensorteil des Gehäuses hermetisch abgedichtet wird,
   wobei
   zuerst an der Trennwand des Sensorteils des Gehäuses und am Schlitz der Trennwand hermetisch abgedichtet wird und anschließend ein elektrisches Anschlusselement, nämlich ein Kabel oder ein elektrischer Steckverbinder, an der Anschlussseite befestigt und mit den Leiterbahnen auf dem Kontaktierungsabschnitt elektrisch verbunden wird.
Mit diesem Verfahren wird dementsprechend ein hermetisch verkapselter Sensor erhalten, welcher
- ein Gehäuse,
- zumindest ein Sensorelement zur Erfassung einer physikalischen Größe umfasst, und
- eine elektronische Schaltung auf
- einer Leiterplatte umfasst, wobei
- das Sensorelement an
- eine elektronische Schaltung auf der Leiterplatte angeschlossen ist, wobei
- auf der Leiterplatte Leiterbahnen vorgesehen sind, welche Anschlusselemente für die elektronische Schaltung bilden, und wobei
- die Leiterplatte einen an einer Kante der Leiterplatte angrenzenden Kontaktierungsabschnitt, sowie
- einen Bestückungsabschnitt aufweist, welcher mit den elektronischen Bauelementen der Schaltung des Sensors bestückt ist, wobei
- die Leiterbahnen vom Bestückungsabschnitt zum Kontaktierungsabschnitt hin verlaufen, so dass sie jeweils auf der Leiterplattenseite, auf der die Leiterbahn verläuft, am Kontaktierungsabschnitt kontaktierbar sind,
- wobei die Leiterplatte in ein Gehäuse eingesetzt ist, welches die Seiten der Leiterplatte umgibt, und wobei
- das Gehäuse eine Anschlußseite aufweist, und
- im Gehäuse an der Anschlußseite eine gegenüber dem Gehäuseende zurückgesetzte Trennwand angeordnet ist, welche den Raum des Sensorgehäuses in einen Anschlußteil und einen in Richtung auf die Anschlußseite gesehen hinter der Trennwand liegenden Sensorteil unterteilt, und wobei
- die Trennwand einen Schlitz aufweist, wobei
- die Leiterplatte so eingesetzt und im Gehäuse fixiert ist, dass deren Bestückungsabschnitt im Sensorteil des Gehäuses angeordnet ist und deren Anschlussabschnitt und die darauf verlaufenden Leiterbahnen durch den Schlitz in den Anschlussteil des Sensorgehäuses hineinragen, und wobei
- ein elektrisches Anschlusselement an der Anschlussseite befestigt und mit den Leiterbahnen auf dem Kontaktierungsabschnitt elektrisch verbunden ist, und
- an der Trennwand des Gehäuses der Sensorteil des Gehäuses hermetisch mittels einer Abdichtung abgedichtet ist,
wobei der Anschlussabschnitt der Leiterplatte aus der Abdichtung herausragt.

Mit der Erfindung wird eine funktionelle Trennung der Einhäusung des Sensors und der Art und Weise des elektrischen Anschlusses erzielt. Damit können nun verschiedene elektrische Anschlusselemente gewählt und am Anschlussabschnitt mit den Leiterbahnen verbunden werden, wobei die Sensorplatine, beziehungsweise genauer bereits vorher durch die Trennwand im Sensorteil des Gehäuses eingehäust wird.

Die gegenüber der anschlußseitigen Gehäuseöffnung zurückgesetzte Trennwand ermöglicht eine gute Verankerung des elektrischen Anschlusselements am Sensorgehäuse. Die Verankerung kann auf diese Weise an der den Anschlussteil des Gehäuses umgebenden Innenwandung erfolgen.

Besonders geeignet für eine hermetische Verkapselung an der Anschlußseite ist ein Kunststoffverguss oder eine Kunststoffumspritzung. Der Verguss kann gleichzeitig neben der Verkapselung auch die Fixierung des elektrischen Anschlusselements bewirken oder unterstützen. Ein Verguss, beziehungsweise eine Umspritzung kann sowohl durch ein aushärtendes Giesharz, als auch durch eine Umspritzung mit einem durch Erhitzung erweichten oder verflüssigten thermoplastischen Kunststoff, beispielsweise mit einem Heißkleber erfolgen.

Weiterhin ist es für die Verkapselung in Weiterbildung der Erfindung günstig, wenn ein hermetischer Verschluss des Sensorteils des Gehäuses am Schlitz der Trennwand erfolgt. Mit einem solchen hermetischen Verschluss wird dann ein bereits versiegelter Sensorkopf erzielt, der dann mit einem geeigneten elektrischen Anschlusselement konfektioniert werden kann, so dass beispielsweise unterschiedlichen Kundenanforderungen hinsichtlich der Anschlussart Rechnung getragen werden kann.

Die Abdichtung kann auf der anschlußseitigen Seite der Trennwand erfolgen, so dass der Anschlussabschnitt der Leiterplatte aus der Abdichtung herausragt. Alternativ oder zusätzlich kann die Abdichtung auch innenseitig, beziehungsweise auf der zum Sensorteil des Gehäuses weisenden Seite der Trennwand erfolgen.

Die Abdichtung des Sensorteils des Gehäuses und die Fixierung des Anschlusselements können sowohl in einem Schritt, als auch in getrennten Schritten durchgeführt werden. So können wie oben beschrieben am Schlitz der Trennwand abgedichtete Sensoren ohne Anschlusselement vorbereitet werden. Je nach Anforderung wird dann das Anschlusselement an die Leiterbahnen des Anschlussabschnitts der Leiterplatte angeschlossen und nochmals fixiert.

Gemäß einer Ausführungsform der Erfindung wird ein Kabel als Anschlusselement verwendet. Im einfachsten Fall können die Litzen des Kabels zur Kontaktierung des Sensors auf die Leiterbahnen des Kontaktierungsabschnittes aufgelötet werden. Auch ein Anklemmen ist aber beispielsweise denkbar.

Eine weitere Möglichkeit ist die Kontaktierung und Fixierung eines elektrischen Steckverbinders als Anschlusselement. Dieser kann beispielsweise ebenfalls aufgelötet und dann mit einer Vergussmasse fixiert werden. Auch eine Verklebung, Verschweißung oder ein Aufschrumpfen ist möglich.

Insbesondere für letzteren Fall kann vorgesehen werden, das elektrische Anschlusselement mittels eines Kunststoff-Formteils an der Anschlussseite zu befestigen. Das Kunststoff-Formteil kann in Weiterbildung der Erfindung auch einen hermetischen Abschluss des Gehäuses oder zumindest des Anschlussteils des Gehäuses bewirken. Die Verankerung des Kunststoff-Formteils kann sowohl an der Gehäusewandung im Bereich des Anschlussteils, als auch an der Trennwand erfolgen.

Die Erfindung wird nachfolgend genauer anhand von Ausführungsbeispielen und den beigeschlossenen Zeichnungen näher erläutert. In den Zeichnungen bezeichnen gleiche Bezugszeichen jeweils gleiche oder entsprechende Elemente. Es zeigen:
Fig. 1 einen Querschnitt durch ein erstes Ausführungsbeispiel eine Sensors mit Verkapselung und einem Kabelanschluss,
Fig. 2 eine Variante der in Fig. 1 gezeigten Ausführungsform, und
Fig. 3 ein Ausführungsbeispiel mit einem elektrischen Steckverbinder,
Fig. 4 und 5 Teile eines gehäusten Sensors mit einem Signalübertragungselement.

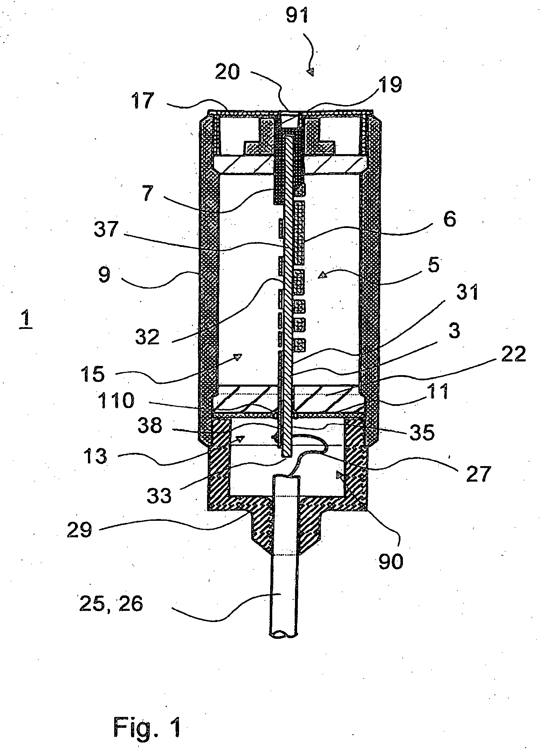

Fig. 1 zeigt in Querschnittansicht einen gehäusten Sensor 1. Der Sensor 1 umfasst eine Leiterplatte 3 mit Leiterplattenseiten 31, 32. Die Leiterplatte 1 ist mit elektronischen Bauelementen 6 einer elektronischen Schaltung 5 des Sensors 1 bestückt.

Weiterhin ist die Leiterplatte 3 auch mit dem Sensorelement 7 als Bestandteil der elektronischen Schaltung, beziehungsweise der elektronischen Bauelemente 6 bestückt. Je nach Ausprägung des Sensorelements muss dieses aber nicht direkt auf die Leiterplatte 3 gelötet sein, sondern kann von der Leiterplatte 3 getrennt angeordnet und mit der elektronischen Schaltung, beispielsweise über einen Steckverbinder oder eine Kabelverbindung elektrisch verbunden werden. Jedenfalls ist aber das Sensorelement an die elektronische Schaltung angeschlossen und bildet damit einen Teil dieser Schaltung. Das Sensorelement 7 kann je nach Bauart für die Erfassung unterschiedlichster physikalischer Größen ausgebildet sein. Beispielsweise kann das Sensorelement ein photoempfindliches Element, wie etwa ein Phototransistor oder eine Photodiode sein. Auch kann unter anderem ein magnetisches Sensorelement, wie es unter anderem für Drehgeber verwendet wird, eingesetzt werden.

Die Leiterplatte 3 weist einen an einer Kante 33 der Leiterplatte angrenzenden Kontaktierungsabschnitt 35, sowie einen Bestückungsabschnitt 37 auf, der mit den elektronischen Bauelementen 6 bestückt ist. Weiterhin sind auf der Leiterplatte 3 Leiterbahnen 38 vorgesehen, die Anschlusselemente für die elektronische Schaltung 5 bilden. Die Leiterbahnen 38 verlaufen vom Bestückungsabschnitt 33 zum Kontaktierungsabschnitt 35, so dass sie jeweils auf der Leiterplattenseite, auf der die Leiterbahn verläuft, hier also die Leiterplattenseite 32, am Kontaktierungsabschnitt 35 zum Zwecke der Signalabnahme und gegebenenfalls zur Energieversorgung kontaktierbar sind.

Die Leiterplatte 3 mit den elektronischen Bauelementen 6 und dem Sensorelement 7 der elektronischen Schaltung 5 ist in ein Gehäuse 9 eingesetzt. Das die Leiterplattenseiten 31, 32 umgebende Gehäuse 9 ist in diesem Ausführungsbeispiel röhrenförmig ausgebildet. Die Enden dieses Gehäuses bilden eine Kopfseite 91 und eine Anschlußseite 90, An der Anschlußseite 90 des Gehäuses 9 ist eine gegenüber dem Gehäuseende zurückgesetzte Trennwand 11 angeordnet. Diese Trennwand 11 unterteilt den Raum des Gehäuses 9 in einen Anschlußteil 13 und einen Sensorteil 15. Weiterhin weist die Trennwand 11 einen Schlitz 110 auf.

Als Material für das Gehäuse 9 kommt allgemein, ohne Beschränkung auf das in Fig. 1 gezeigte Ausführungsbeispiel, unter anderem Metall, Kunststoff oder ein Verbundwerkstoff in Frage. Die Trennwand 11 kann elektrisch leitend ausgebildet sein. Dies kann beispielsweise zur kapazitiven Ein- oder Auskopplung von Signalen und/oder zur Abschirmung des Innenraums von Vorteil sein.

Die Leiterplatte 3 wird bei der Montage des Sensors 1 nun mit dem Kontaktierungsabschnitt 35 in den Schlitz 110 eingeführt, so dass der Kontaktierungsabschnitt 35 mit den darauf verlaufenden Leiterbahnen 38 in den Anschlussteil 13 hineinragt und damit die Leiterbahnen 38 an der Anschlußseite zugänglich sind und kontaktiert werden können. Der Bestückungsabschnitt 37 der Leiterplatte 3 mit den elektronischen Bauelementen 6 der elektronischen Schaltung 5 ist entsprechend im Sensorteil 15 des Gehäuses 9 angeordnet.

Die Fixierung der Leiterplatte kann an der Kopfseite 91 durch Aufsetzen eines Gehäusekopfes 17 erfolgen. Der Gehäusekopf 17 weist in diesem Fall eine Aufnahme 19, beziehungsweise allgemein ein oder mehrere Positionierelemente für das Sensorelement 7 auf, mit welchen das Sensorelement 7 und damit auch die Leiterplatte 3 in definierter Position gehalten wird. Um am Gehäusekopf 17 einen hermetischen Abschluss zu erzielen, wird der Gehäusekopf 17 mit der Wandung des Gehäuses 3 dichtend verbunden. Beispielsweise kann der Gehäusekopf 17 mit der Wandung des Gehäuses 3 dazu verschweißt, aufgeschrumpft, verklebt oder mit O-Ring abgedichtet werden. Ist die Aufnahme 19 nach außen hin offen, so kann zusätzlich eine Abdichtung zwischen Sensorelement 7 und Aufnahme 19 vorgenommen werden. Beispielsweise kann dazu das Sensorelement 7 mit der Aufnahme verklebt werden. Möglich bei optischen Sensoren ist auch, ein dichtendes Fenster 20 als Bestandteil des Gehäusekopfs 17 vorzusehen.

Weiterhin erfolgt eine hermetische Abdichtung des Gehäuses 9 im Bereich der Anschlußseite 90. Diese Abdichtung kann sowohl an der Trennwand 11 erfolgen, als auch am Anschlußteil 13 des Gehäuses 9.

Außerdem wird ein elektrisches Anschlusselement an der Anschlussseite 90 befestigt und mit den Leiterbahnen 38 auf dem Kontaktierungsabschnitt 35 der Leiterplatte elektrisch verbunden.

Diese beiden Schritte können getrennt oder zusammen erfolgen. Im letzteren Fall kann insbesondere das Fixieren des elektrischen Anschlusselements gleichzeitig eine hermetische Abdichtung bewirken.

Weiterhin kann ohne Beschränkung auf das in Fig. 1 gezeigte Ausführungsbeispiel auch sowohl eine hermetische Abdichtung an der Trennwand einerseits und eine weitere hermetische Abdichtung des Anschlussteils 13 des Gehäuses 9 gegenüber der Umgebung erfolgen. Demgemäß sind bei dieser Ausführungsform zwei hermetische Abdichtungen vorhanden, wovon die Abdichtung an der Trennwand einen hermetischen Abschluss des Sensorteils 15 gegenüber dem Anschlussteil 13 des Gehäuses und eine zweite Abdichtung einen hermetischen Abschluss des Anschlussteils 13 gegenüber der Umgebung darstellt.

Eine derartige doppelte Abdichtung ist auch bei dem in Fig. 1 gezeigten Ausführungsbeispiel verwirklicht. Um zunächst eine Abdichtung des Sensorteils 15 an der Trennwand zu bewerkstelligen, wird an der Trennwand 11 zumindest im Bereich des Schlitzes 110 ein Kunststoffverguss 22 eingefügt. Geeignet ist beispielsweise ein Gießharz. Auch ein Verguss mit einem heißen, verflüssigten thermoplastischen Kunststoff ist beispielsweise möglich. Auch eine Abdichtung mittels Dichtlippen ist möglich.

Bei dem in Fig. 1 gezeigten Beispiel ist der Kunststoffverguss 22 auf der zum Sensorteil des Gehäuses weisenden Seite der Trennwand 11 eingefügt. Ebenso ist aber auch ein Verguss an der anschlußseitigen Seite der Trennwand 11 möglich. Mit dem Kunststoffverguss 22 wird in beiden Fällen am Schlitz 110 in der Trennwand 11 der Sensorteil 15 des Gehäuses 9 hermetisch gegenüber dem Anschlussteil 13 abgedichtet.

Als elektrisches Anschlusselement 25 ist bei dem in Fig. 1 gezeigten Beispiel ein Kabel 26 vorgesehen. Dessen Litzen 27 sind mit den Leiterbahnen 38 verlötet.

Als zusätzliche Abdichtung ist ein Kunststoffformteil 29 vorgesehen, welches das Kabel 26 umschließt und mit der Wandung des Gehäuses 9 dichtend verbunden wird. Geeignet hierfür ist ähnlich wie bei der Fixierung des Gehäusekopfes 17 beispielsweise wieder eine Verschweißung oder Verklebung. Auf diese Weise wird auch ein hermetischer Abschluss des Anschlußteils 13 des Gehäuses 3 erreicht. Um am Kabel 26 eine dichtende Verbindung mit dem Kunststoff-Formteil zu erzielen, ist in Weiterbildung der Erfindung vorgesehen, das Kunststoff-Formteil durch Umspritzen des Kabels 26 herzustellen. Als Kunststoffe für das Kunststoff-Formteil 29 kommen unter anderem Heißkleber und/oder Polyamid-Kunststoffe in Betracht.

Eine hermetische Abichtung des Schlitzes 110 bietet den Vorteil, dass die Sensoren vorgefertigt und hermetisch abgedichtet vorgehalten werden können, ohne bereits kunden-oder anwendungsspezifische Anschlußstrukturen vorsehen zu müssen. Die Anschlußelemente können auf diese Weise später ausgewählt und angebracht werden. Aus diesem Grund sieht die Erfindung auch allgemein, ohne Beschränkung auf die in Fig. 1 gezeigte Ausführungsform einen Sensor mit hermetisch verkapselter Sensorelektronik vor, welcher ein Gehäuse 9, zumindest ein Sensorelement 7 zur Erfassung einer physikalischen Größe, und eine elektronische Schaltung 5 auf einer Leiterplatte 3 umfasst, wobei das Sensorelement 7 an der elektronischen Schaltung 5 auf der Leiterplatte 3 angeschlossen ist, wobei auf der Leiterplatte 3 Leiterbahnen 38 vorgesehen sind, welche Anschlusselemente für die elektronische Schaltung 5 bilden, und wobei
- die Leiterplatte 3 einen an einer Kante 33 der Leiterplatte 3 angrenzenden Kontaktierungsabschnitt 35, sowie einen Bestückungsabschnitt 37 aufweist, welcher mit den elektronischen Bauelementen 6 der elektronischen Schaltung 5 des Sensors 1 bestückt ist, wobei die Leiterbahnen 38 vom Bestückungsabschnitt zum Kontaktierungsabschnitt 35 hin verlaufen, so dass sie jeweils auf der Leiterplattenseite 32, auf der die Leiterbahn 38 verläuft, am Kontaktierungsabschnitt 35 kontaktierbar sind, und wobei die Leiterplatte 3 in ein Gehäuse 9 eingesetzt ist, welches die Seiten der Leiterplatte 3 umgibt, und wobei
- das Gehäuse 9 eine Anschlußseite 90 aufweist, und
- im Gehäuse 9 an der Anschlußseite 90 eine gegenüber dem anschlußseitigen Gehäuseende zurückgesetzte Trennwand 11 angeordnet ist, welche den Raum des Gehäuses 9 in einen Anschlußteil 13 und einen in Richtung auf die Anschlußseite 90 gesehen hinter der Trennwand 11 liegenden Sensorteil unterteilt, und wobei die Trennwand 11 einen Schlitz 110 aufweist, wobei die Leiterplatte 3 so eingesetzt und im Gehäuse 9 fixiert ist, dass deren Bestückungsabschnitt im Sensorteil des Gehäuses 9 angeordnet ist und deren Anschlussabschnitt und die darauf verlaufenden Leiterbahnen 38 durch den Schlitz 110 in den Anschlussteil des Gehäuses 9 hineinragen, und wobei am Schlitz 110 der Trennwand 11 der Sensorteil 15 des Gehäuses 9 hermetisch mittels einer Abdichtung abgedichtet ist.

Ohne Anschlußelement stellt ein solcher Sensor eine hermetisch abgedichtete Anordnung mit zugänglichen und noch kontaktierbaren Leiterbahnen auf dem aus dem Schlitz herausragenden Kontaktierungsabschnitt der Leiterplatte dar.

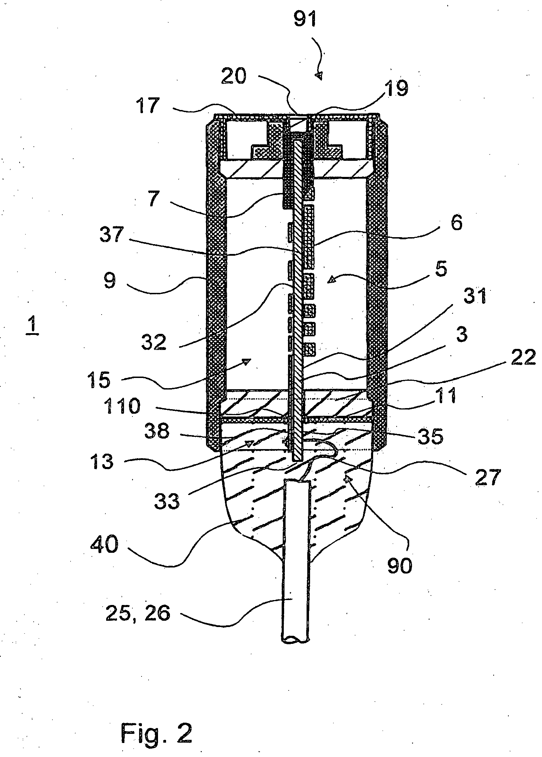

Fig. 2 zeigt eine Variante des in Fig. 1 dargestellten Ausführungsbeispiels. Bei dieser Variante wurde anstelle eines Kunststoff-Formteils ein zweiter Kunststoffverguss 40 verwendet, um das elektrische Anschlusselement 25, hier speziell wieder ein Kabel 26 zu fixieren.

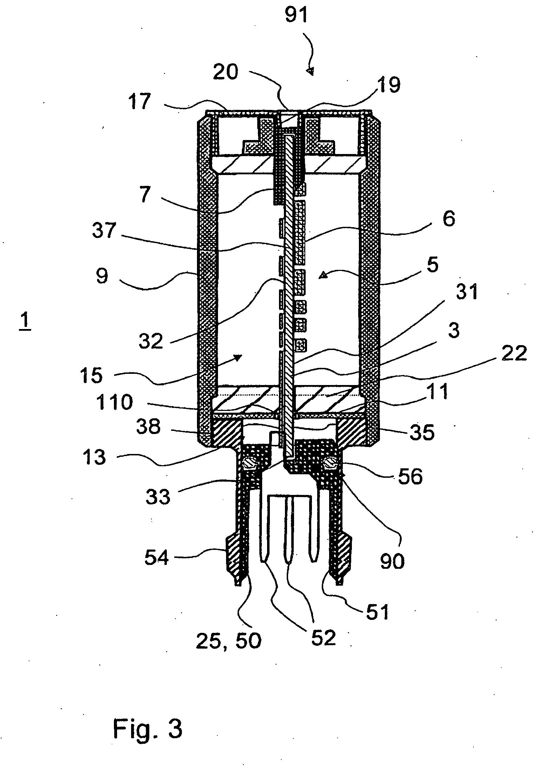

Fig. 3 zeigt ein weiteres Ausführungsbeispiel. Im Unterschied zu den oben beschriebenen Ausführungsbeispielen dient hier ein elektrischer Steckverbinder 50 als elektrisches Anschlusselement. Der Steckverbinder 50 weist elektrische Anschlusskontakte 52 auf, welche die Leiterbahnen 38 am aus der Trennwand (11) herausragenden Kontaktierungsabschnitt 35 der Leiterplatte 3 kontaktieren. Auf den elektrischen Steckverbinder 50 kann dann ein passender Gegenstecker aufgesteckt werden.

Der Steckverbinder 50 umfasst als Steckerkörper 51 ein Kunststoff-Formteil, in welches die elektrischen Anschlusskontakte 52 eingebettet sind.

Der Steckerkörper 51 kann entsprechend zu dem in Fig. 1 gezeigten Ausführungsbeispiel mit dem Gehäuse 9 im Anschlussteil 13 verbunden werden. In Weiterbildung der Erfindung, wie sie auch in Fig. 3 dargestellt ist, kann aber auch in den Anschlussteil 13 des Gehäuses 9 ein Formteil eingesetzt werden, welches eine Aufnahme 54 für den elektrischen Steckverbinder 50 bildet. Diese Aufnahme 54 kann wieder mit dem Gehäuse 9 wie das Kunststoff-Formteil 29 des in Fig. 1 gezeigten Beispiels mit dem Gehäuse 9 durch Verschweissen, Einpressen, Verkleben oder Aufschrumpfen verbunden werden. Um eine kunden- oder anforderungsspezifische Ausrüstung des Sensors 1 mit einem geeigneten Stecker zu erleichtern, kann in Weiterbildung der Erfindung der elektrische Steckverbinder in die Aufnahme 54 eingesteckt werden und verrasten.

Um gegebenenfalls auch ohne Verklebung oder Verschweißung einen dichtenden Sitz des Steckerkörpers 51 zu erreichen, ist gemäß noch einer Weiterbildung der Erfindung eine O-Ring-Dichtung vorgesehen, welche den Steckerkörper gegenüber der Aufnahme 54 abdichtet. Ist der Übergang zwischen diesen beiden Elementen abgedichtet, so liegt auch wiederum ein hermetischer Einschluss des Anschlussteils 1 des Gehäuses 9 vor.

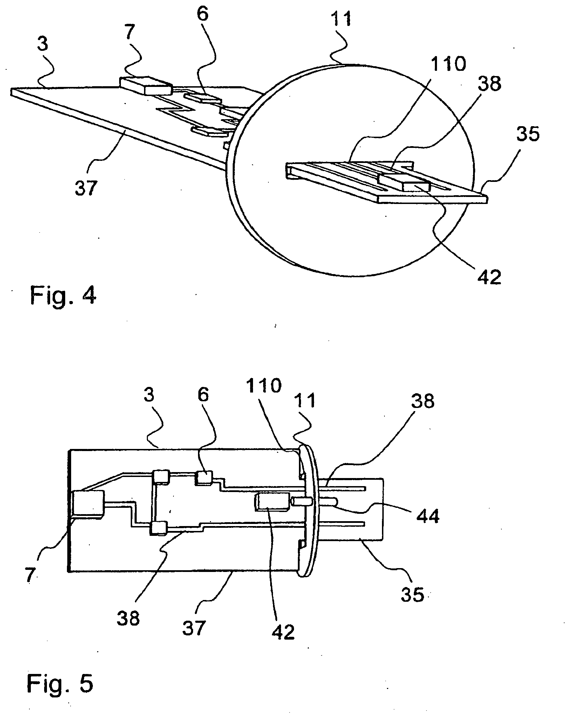

Fig. 4 zeigt die bestückte Leiterplatte 3 und die Trennwand 11 eines weiteren Ausführungsbeispiels der Erfindung. Wie anhand der perspektivischen Ansicht der Fig. 4 zu erkennen ist, ist der Kontaktierungsabschnitt 35 schmaler gegenüber dem Bestückungsabschnitt 37 der Leiterplatte 3. Auch bei den Ausführungsbeispielen der Fig. 1 bis Fig. 3 kann der Kontaktierungsabschnitt entsprechend geformt sein, um die Breite des Schlitzes 110 in der Trennwand 11 zu reduzieren.

Auf dem Kontaktierungsabschnitt 35 ist bei dem in Fig. 4 gezeigten Ausführungsbeispiel ein Signalübertragungselement, beispielsweise in Form eines Transmitters, Receivers oder Transceivers angeordnet. Im speziellen kann dazu eine Leuchtdiode 42 oder ein Optokoppler verwendet werden. Mit dem Signalübertragungselement können beispielsweise Signalwerte optisch umgesetzt werden. Die Signalübertragung kann auf diese Weise optisch, etwa über einen an die Leuchtdiode angekoppelten Lichtleiter erfolgen. Wird beispielsweise ein transparenter Anschluss oder transparenter Kunststoffverguss an der Anschlußseite eingesetzt, kann die Leuchtdiode auch zur Funktionsanzeige verwendet werden. Der Schlitz 110 und/oder die Höhe des Signalübertragungselements können vorteilhaft so bemessen sein, dass der mit dem Signalübertragungselement bestückte Anschlußabschnitt 35 der Leiterplatte 3 durch den Schlitz 110 hindurchgesteckt werden kann.

Fig. 5 zeigt in perspektivischer Ansicht ein weiteres Ausführungsbeispiel einer Leiterplatte 3 mit einem Signalübertragungselement. Auch hier umfasst das Signalübertragungselement wieder eine Leuchtdiode 42. Im Unterschied zu der in Fig. 4 gezeigten Ausführungsform ist hier das Signalübertragungselement aber auf dem Bestückungsabschnitt 37 der Leiterplatte 3 angeordnet. Um die Signale in den Anschlussteil 13 des Gehäuses zu leiten, ist bei diesem Ausführungsbeispiel ein Lichtleiter 44 durch die Trennwand 11 hindurchgeführt. Alternativ kann ein Lichtleiter 42 auch auf der Platine angeordnet sein. Gemäß noch einer weiteren Ausführungsform kann die Trennwand auch transparent ausgebildet sein, so daß diese das Licht der Leuchtdiode 42 transmittiert.

### Bezugszeichenliste

- 1: Sensor
- 3: Leiterplatte
- 5: elektronische Schaltung
- 6: elektronische Bauelemente von 5
- 7: Sensorelement
- 9: Gehäuse
- 11: Trennwand
- 13: Anschlussteil von 9
- 15: Sensorteil von 9
- 17: Gehäusekopf
- 19: Aufnahme für 7
- 20: Fenster
- 22, 40: Kunststoffverguss
- 25: elektrisches Anschlusselement
- 26: Kabel
- 27: Litzen von 26.
- 29: Kunststoff-Formteil
- 31, 32: Leiterplattenseiten von 3
- 33: Kante von 3
- 35: Kontaktierungsabschnitt von 3
- 37: Bestückungsabschnitt von 3
- 38: Leiterbahnen
- 40: Kunststoffverguss
- 42: Leuchtdiode
- 44: Lichtleiter
- 50: elektrischer Steckverbinder
- 51: Steckerkörper
- 52: elektrische Anschlusskontakte von 50
- 54: Aufnahme für 50
- 90: Anschlußseite von 9
- 91: Kopfseite von 9
- 110: Schlitz in 11

## Patentansprüche

1. Verfahren zur hermetischen Verkapselung eines Sensors (1) in einem Gehäuse (9), wobei der Sensor (1) zumindest ein Sensorelement (7) zur Erfassung einer physikalischen Größe umfasst, und das Sensorelement (7) an eine elektronische Schaltung (5) auf einer Leiterplatte (3) angeschlossen ist, wobei auf der Leiterplatte (3) Leiterbahnen (38) vorgesehen sind, welche Anschlusselemente für die elektronische Schaltung (5) bilden, und wobei die Leiterplatte (3) einen an einer Kante (33) der Leiterplatte (3) angrenzenden Kontaktierungsabschnitt (35), sowie einen Bestückungsabschnitt (37) aufweist, welcher mit den elektronischen Bauelementen (6) der Schaltung (5) des Sensors (1) bestückt ist, wobei die Leiterbahnen (38) vom Bestückungsabschnitt (37) zum Kontaktierungsabschnitt (35) hin verlaufen, so dass sie jeweils auf der Leiterplattenseite (32), auf der die Leiterbahn (38) verläuft, am Kontaktierungsabschnitt (35) kontaktierbar sind,
- wobei die Leiterplatte (3) in ein Gehäuse (9) eingesetzt wird, welches die Seiten der Leiterplatte (3) umgibt, und wobei das Gehäuse (9) eine Anschlußseite (90) aufweist, und wobei im Gehäuse (9) an der Anschlußseite (90) eine gegenüber dem Gehäuseende zurückgesetzte Trennwand (11) angeordnet ist, welche den Raum des Gehäuses (9) in einen Anschlußteil (13) und einen in Richtung auf die Anschlußseite (90) gesehen hinter der Trennwand (11) liegenden Sensorteil (15) unterteilt, wobei
- die Trennwand (11) einen Schlitz (110) aufweist, und wobei
- die Leiterplatte (3) so eingesetzt wird, dass deren Bestückungsabschnitt (37) im Sensorteil (15) des Gehäuses (9) angeordnet ist und deren Anschlussabschnitt und die darauf verlaufenden Leiterbahnen (38) durch den Schlitz (110) in den Anschlussteil (13) des Gehäuses (9) hineinragen, und die Leiterplatte (3) in dieser Position fixiert wird, und wobei
- ein elektrisches Anschlusselement an der Anschlussseite (90) befestigt und mit den Leiterbahnen (38) auf dem Kontaktierungsabschnitt (35) elektrisch verbunden wird, und
- am Anschlussteil (13) des Gehäuses (9) oder an der Trennwand (11) der Sensorteil (15) des Gehäuses (9) hermetisch abgedichtet wird, wobei
zuerst an der Trennwand (11) des Sensorteils (15) des Gehäuses (9) und am Schlitz (110) der Trennwand (11) hermetisch abgedichtet wird und anschließend ein elektrisches Anschlusselement (25), nämlich ein Kabel (26) oder ein elektrischer Steckverbinder (50), an der Anschlussseite (90) befestigt und mit den Leiterbahnen (38) auf dem Kontaktierungsabschnitt (35) elektrisch verbunden wird.

2. Verfahren gemäß dem vorstehenden Anspruch, **dadurch gekennzeichnet, dass** am Schlitz (110) in der Trennwand (11) der Sensorteil (15) des Gehäuses (9) hermetisch abgedichtet wird.

3. Verfahren gemäß einem der vorstehenden Ansprüche, **dadurch gekennzeichnet, dass** die Abdichtung mit einem Kunststoffverguss (22) oder einer Kunststoffumspritzung erfolgt.

4. Verfahren gemäß einem der vorstehenden Ansprüche, **dadurch gekennzeichnet, dass** ein Kabel oder ein elektrischer Steckverbinder an die Leiterbahnen (38) des Kontaktierungsabschnittes (35) der Leiterplatte (3) angeschlossen und am Gehäuse (9) fixiert wird.

5. Verfahren gemäß einem der vorstehenden Ansprüche, **dadurch gekennzeichnet, dass** das elektrische Anschlusselement mittels eines Kunststoff-Formteils am Anschlussteil (13) des Gehäuses (9) befestigt ist.

6. Verfahren gemäß einem der vorstehenden Ansprüche, **dadurch gekennzeichnet, dass** zwei hermetische Abdichtungen vorgesehen werden, wovon eine Abdichtung an der Trennwand (11) einen hermetischen Abschluss des Sensorteils (15) gegenüber dem Anschlussteil (13) des Gehäuses (9) und eine zweite Abdichtung einen hermetischen Abschluss des Anschlüssteils (13) gegenüber der Umgebung darstellt.

7. Hermetisch verkapselter Sensor, umfassend
- ein Gehäuse (9),
- zumindest ein Sensorelement (7) zur Erfassung einer physikalischen Größe umfasst, und
- eine elektronische Schaltung (5) auf
- einer Leiterplatte (3), wobei
- das Sensorelement (7) an
- der elektronischen Schaltung (5) auf der Leiterplatte (3) angeschlossen ist, wobei
- auf der Leiterplatte (3) Leiterbahnen (38) vorgesehen sind, welche Anschlusselemente für die elektronische Schaltung (5) bilden, und wobei
- die Leiterplatte (3) einen an einer Kante (33)der Leiterplätte (3) angrenzenden Kontaktierungsabschnitt (35), sowie
- einen Bestückungsabschnitt (37) aufweist, welcher mit den elektronischen Bauelementen der Schaltung des Sensors (1) bestückt ist, wobei
- die Leiterbahnen (38) vom Bestückungsabschnitt (37) zum Kontaktierungsabschnitt (35) hin verlaufen, so dass sie jeweils auf der Leiterplattenseite (32), auf der die Leiterbahn (38) verläuft, am Kontaktierungsabschnitt (35) kontaktierbar sind,
- wobei die Leiterplatte (3) in ein Gehäuse (9)eingesetzt ist, welches die Seiten der Leiterplatte (3) umgibt, und wobei
- das Gehäuse (9) eine Anschlußseite (90) aufweist, und
- im Gehäuse (9) an der Anschlußseite (90) eine gegenüber dem Gehäuseende zurückgesetzte Trennwand (11) angeordnet ist, welche den Raum des Gehäuses (9) in einen Anschlußteil und einen in Richtung auf die Anschlußseite (90) gesehen hinter der Trennwand (11) liegenden Sensorteil unterteilt, und wobei
- die Trennwand (11) einen Schlitz (110) aufweist, wobei
- die Leiterplatte (3) so eingesetzt und im Gehäuse (9) fixiert ist, dass deren Bestückungsabschnitt (37) im Sensorteil (15) des Gehäuses (9) angeordnet ist und deren Anschlussabschnitt (35) und die darauf verlaufenden Leiterbahnen (38) durch den Schlitz (110) in den Anschlussteil des Gehäuses (9) hineinragen, und wobei
- ein elektrisches Anschlusselement (25) an
der Anschlussseite (90) befestigt
und mit den Leiterbahnen (38) auf dem Kontaktierungsabschnitt (35) elektrisch verbunden ist, und
- an der Trennwand (11) der
Sensorteil des Gehäuses (9) hermetisch mittels einer Abdichtung abgedichtet ist, wobei der Anschlussabschnitt der Leiterplatte (3) aus der Abdichtung herausragt.

8. Hermetisch verkapselter Sensor (1) gemäß vorstehendem Anspruch,
**gekennzeichnet durch** eine hermetische Abdichtung am Schlitz (110)in der Trennwand (11).

9. Hermetischverkapselfier Sensor (1) gemäß einem der beiden vorstehenden Ansprüche, **dadurch gekennzeichnet, dass** die Abdichtung mit einem Kunststöffverguss (22) oder einer Kunststoffumspritzung erfolgt.

10. Hermetisch verkapselter Sensor (1) gemäß einem der drei vorstehenden Ansprüche, **dadurch gekennzeichnet, dass** ein Kabel oder ein elektrischer Steckverbinder an die Leiterbahnen (38) des Kontaktierungsabschnittes (35) der Leiterplatte (3) angeschlossen und am Gehäuse (9) fixiert ist:

11. "Hermetisch verkapselter Sensor (1) gemäß einem der vier vorstehenden Ansprüche, **dadurch gekennzeichnet, dass** das elektrische Anschlusselement mittels eines Kunststoff-Formteils am Anschlussteil des Gehäuses (3) befestigt ist.

12. Hermetisch verkapselter Sensor (1) gemäß einem der fünf vorstehenden Ansprüche, **gekennzeichnet durch** zwei hermetische Abdichtungen, wovon eine Abdichtung an der Trennwand einen hermetischen Abschluss des Sensorteils (15) gegenüber dem Anschlussteil (13) des Gehäuses und eine zweite Abdichtung einen hermetischen Abschluss des Anschlussteils (13) gegenüber der Umgebung darstellt.

13. Hermetisch verkapselter Sensor (1) gemäß einem der sechs vorstehenden Ansprüche, wobei das elektrische Anschlusselement einen elektrischen Steckverbinder umfasst.

14. Hermetisch verkapselter Sensor (1) gemäß dem vorstehenden Anspruch, wobei in den Anschlussteil (13) des Gehäuses (9) ein Formteil eingesetzt ist, welches eine Aufnahme (54) für einen elektrischen Steckverbinder bildet, und wobei in die Aufnahme (54) ein elektrischer Steckverbinder eingesetzt ist, dessen elektrische Anschlusskontakte (52) die Leiterbahnen (38) am aus der Trennwand (11) herausragenden Kontaktierungsabschnitt (35) der Leiterplatte (3) kontaktieren.

## Claims

1. Procedure for the hermetic encapsulation of a sensor (1) in a housing (9), whereby the sensor (1) comprises at least one sensing element (7) for recording a physical quantity, and the sensing element (7) is connected to an electronic circuit (5) on a printed circuit board (3), whereby conductor tracks (38) are provided on the printed circuit board (3) representing connecting elements for the electronic circuit (5), and whereby the printed circuit board (3) has a contacting section (35) adjacent to an edge (33) of the printed circuit board (3), as well as a mounting section (37) which is equipped with the electronic components (6) of the circuit (5) of the sensor (1), whereby the conductor tracks (38) run from the mounting section (37) to the contacting section (35) in such a way that each can be contacted on the contacting section (35) on the printed circuit board side (32) on which the conductor track (38) runs,
- whereby the printed circuit board (3) is inserted in a housing (9) which surrounds the sides of the printed circuit board (3), and whereby the housing (9) has one connecting side (90), and whereby a partition (11) recessed in relation to the end of the housing is positioned in the housing (9) on the connecting side (90), said partition dividing the compartment of the housing (9) into a connecting part (13) and a sensor part (15) located behind the partition (11) in the direction of the connecting side (90), whereby
- the partition (11) has a slot (110), and whereby
- the printed circuit board (3) is inserted in such a way that its mounting section (37) is located in the sensor part (15) of the housing (9) and its connecting section and the conductor tracks (38) running there project through the slot (110) into the connecting part (13) of the housing (9), and the printed circuit board (3) is fixed in this position, and whereby
- an electric connecting element is attached on the connecting side (90) and is electrically connected to the conductor tracks (38) on the contacting section (35), and
- the sensor part (15) of the housing (9) is hermetically sealed at the connecting part (13) of the housing (9) or at the partition (11) , whereby the hermetic seal is first provided at the partition (11) of the sensor part (15) of the housing (9) and at the slot (110) of the partition (11) and, subsequently, an electric connecting element (25), namely a cable (26) or an electric plug connector (50), is attached on the connecting side (90) and electrically connected with the conductor tracks (38) on the contacting section (35).

2. Procedure in accordance with the above-mentioned Claim, **characterized in that** the sensor part (15) of the housing (9) is hermetically sealed at the slot (110) in the partition (11).

3. Procedure in accordance with one of the above-mentioned Claims, **characterized in that** the seal is effected with a synthetic casting (22) or a surrounding synthetic molding.

4. Procedure in accordance with one of the above-mentioned Claims, **characterized in that** a cable or an electric plug connector is connected to the conductor tracks (38) of the contacting section (35) of the printed circuit board (3) and attached to the housing (9).

5. Procedure in accordance with one of the above-mentioned Claims, **characterized in that** the electric connecting element is attached to the connecting part (13) of the housing (9) by means of a preformed synthetic part.

6. Procedure in accordance with one of the above-mentioned Claims, **characterized in that** two hermetic seals are provided whereof one seal at the partition (11) represents a hermetic seal of the sensor part (15) vis-à-vis the connecting part (13) of the housing (9) and a second seal represents a hermetic seal of the connecting part (13) vis-à-vis the environment.

7. Hermetically encapsulated sensor, comprising
- a housing (9),
- at least one sensing element (7) for recording a physical quantity, and
- an electronic circuit (5) on
- a printed circuit board (3), whereby
- the sensing element (7) is connected to
- the electronic circuit (5) on the printed circuit board (3), whereby
- conductor tracks (38) are provided on the printed circuit board (3) representing connecting elements for the electronic circuit (5), and whereby
- the printed circuit board (3) has a contacting section (35) adjacent to an edge (33) of the printed circuit board (3), as well as
- a mounting section (37), which is equipped with the electronic components of the circuit of the sensor (1), whereby
- the conductor tracks (38) run from the mounting section (37) to the contacting section (35) in such a way that each can be contacted on the contacting section (35) on the printed circuit board side (32) on which the conductor track (38) runs,
- whereby the printed circuit board (3) is inserted in a housing (9) which surrounds the sides of the printed circuit board (3), and whereby
- the housing (9) has one connecting side (90), and
- a partition (11) recessed in relation to the end of the housing is positioned in the housing (9) on the connecting side (90), said partition dividing the compartment of the housing (9) into a connecting part and a sensor part located behind the partition (11) in the direction of the connecting side (90), and whereby
- the partition (11) has a slot (110), whereby
- the printed circuit board (3) is inserted and fixed in the housing (9) in such a way that its mounting section (37) is located in the sensor part (15) of the housing (9) and its connecting section (35) and the conductor tracks (38) running thereon project through the slot (110) into the connecting part of the housing (9), and whereby
- an electric connecting element (25) is attached on the connecting side (90) and is electrically connected to the conductor tracks (38) on the contacting section (35), and
- hermetically sealed at the partition (11) of the sensor part of the housing (9) by means of a seal, whereby the connecting section of the circuit board (3) projects from the seal.

8. Hermetically encapsulated sensor (1) in accordance with the above-mentioned Claim, **characterized by** a hermetic seal at the slot (110) in the partition (11).

9. Hermetically encapsulated sensor (1) in accordance with one of the two above-mentioned Claims, **characterized in that** the seal is effected with a synthetic casting (22) or a surrounding synthetic molding.

10. Hermetically encapsulated sensor (1) in accordance with one of the three above-mentioned Claims, **characterized in that** a cable or an electric plug connector is connected to the the conductor tracks (38) of the contacting section (35) of the printed circuit board (3) and is attached to the housing (9).

11. Hermetically encapsulated sensor (1) in accordance with one of the four above-mentioned Claims, **characterized in that** the electric connecting element is attached to the connecting part of the housing (9) by means of a preformed synthetic part.

12. Hermetically encapsulated sensor (1) in accordance with one of the five above-mentioned Claims, **characterized by** two hermetic seals, of which one seal on the partition represents a hermetic seal of sensor part (15) vis-à-vis the connecting part (13) of the housing, and a second seal represents a hermetic seal of the connecting part (13) vis-à-vis the environment.

13. Hermetically encapsulated sensor (1) in accordance with one of the six above-mentioned Claims, whereby the electric connecting element comprises an electric plug connector.

14. Hermetically encapsulated sensor (1) in accordance with the above-mentioned Claim, whereby a preformed part is inserted in the connecting part (13) of the housing (9), said preformed part forming a holder (54) for an electric plug connector, and whereby an electric plug connector is inserted in the holder (54), and the electric connecting contacts (52) of said plug connector contact the conductor tracks (38) at the contacting section (35) of the printed circuit board (3) projecting from the partition (11).

## Revendications

1. Procédé d'encapsulage hermétique d'un détecteur (1) dans un boîtier (9), le détecteur (1) comprenant au moins un élément de détecteur (7) permettant de détecter une grandeur physique, et l'élément de détecteur (7) étant raccordé à un circuit électronique (5) sur une carte de circuit imprimé (3), des pistes de connexion (38) étant prévues sur la carte de circuit imprimé (3), lesquelles formant des éléments de connexion pour le circuit électronique (5), et la carte de circuit imprimé (3) présentant une partie de contact (35) adjacente à un bord (33) de la carte de circuit imprimé (3), ainsi qu'une partie d'équipement (37), qui est équipée des composants électroniques (6) du circuit (5) du détecteur (1), les pistes de connexion (38) s'étendant de la partie d'équipement (37) vers la partie de contact (35) de façon à pouvoir être soumises au contact sur la partie de contact (35) sur le côté de carte de circuit imprimé (32), sur lequel se trouve la piste de connexion (38),
- la carte de circuit imprimé (3) étant insérée dans un boîtier (9) qui entoure les côtés de la carte de circuit imprimé (3), et le boîtier (9) présentant un côté de connexion (90), et une paroi de séparation (11) reculée par rapport à l'extrémité du boîtier étant disposée dans le boîtier (9) sur le côté de connexion (90), ladite paroi de séparation divisant l'espace du boîtier (9) en une partie de connexion (13) et une partie détecteur (15) située derrière la paroi de séparation (11) vue en direction du côté de connexion (90),
- la paroi de séparation (11) présentant une fente (110), et
- la carte de circuit imprimé (3) étant insérée de telle sorte que sa partie d'équipement (37) est disposée dans la partie détecteur (15) du boîtier (9) et sa partie de connexion et les pistes de connexion (38) se trouvant sur celle-ci entrent dans la partie de connexion (13) du boîtier (9) à travers la fente (110), et la carte de circuit imprimé (3) étant fixée dans cette position, et
- un élément de connexion électrique étant fixé sur le côté de connexion (90) et étant raccordé électriquement aux pistes de connexion (38) sur la partie de contact (35), et
- la partie détecteur (15) du boîtier (9) étant rendue hermétique sur la partie de connexion (13) du boîtier (9) ou sur la paroi de séparation (11), l'étanchéité hermétique étant établie d'abord au niveau de la paroi de séparation (11) de la partie détecteur (15) du boîtier (9) et de la fente (110) de la paroi de séparation (11), puis un élément de connexion électrique (25), c'est-à-dire un câble (26) ou un connecteur enfichable électrique (50), étant fixé au côté de connexion (90) et relié électriquement aux pistes de connexion (38) de la partie de contact (35).

2. Procédé selon la revendication précédente, **caractérisé en ce que** la partie détecteur (15) du boîtier (9) est rendue hermétique au niveau de la fente (110) dans la paroi de séparation (11).

3. Procédé selon l'une des revendications précédentes, **caractérisé en ce que** la garniture est réalisée avec un scellement en plastique (22) ou un enrobage de plastique.

4. Procédé selon l'une des revendications précédentes, **caractérisé en ce qu'**un câble ou un connecteur électrique est raccordé aux pistes de connexion (38) de la partie de contact (35) de la carte de circuit imprimé (3) et fixé au boîtier (9).

5. Procédé selon l'une des revendications précédentes, **caractérisé en ce que** l'élément de connexion électrique est fixé au moyen d'un élément moulé en plastique sur la partie de connexion (13) du boîtier (9).

6. Procédé selon l'une des revendications précédentes, **caractérisé en ce que** deux garnitures hermétiques sont prévues, parmi lesquelles une garniture sur la paroi de séparation (11) constitue une fermeture hermétique de la partie détecteur (15) par rapport à la partie de connexion (13) du boîtier (9) et une seconde garniture une fermeture hermétique de la partie de connexion (13) par rapport à l'environnement.

7. Détecteur encapsulé de manière hermétique comprenant
- un boîtier (9),
- au moins un élément de détecteur (7) permettant de détecter une grandeur physique, et
- un circuit électronique (5) sur
- une carte de circuit imprimé (3),
- l'élément de détecteur (7) étant raccordé
- au circuit électronique (5) sur la carte de circuit imprimé (3),
- des pistes de connexion (38) étant prévues sur la carte de circuit imprimé (3), lesquelles formant des éléments de connexion pour le circuit électronique (5), et
- la carte de circuit imprimé (3) présentant une partie de contact (35) adjacente à un bord (33) de la carte de circuit imprimé (3), ainsi qu'une
- partie d'équipement (37) qui est équipée des composants électroniques du circuit du détecteur (1),
- les pistes de connexion (38) s'étendant de la partie d'équipement (37) vers la partie de contact (35) de façon à pouvoir être soumises au contact sur la partie de contact (35) sur le côté de carte de circuit imprimé (32), sur lequel se trouve la piste de connexion (38),
- la carte de circuit imprimé (3) étant insérée dans un boîtier (9) qui entoure les côtés de la carte de circuit imprimé (3), et
- le boîtier (9) présentant un côté de connexion (90), et
- et une paroi de séparation (11) reculée par rapport à l'extrémité du boîtier étant disposée dans le boîtier (9) sur le côté de connexion (90), ladite paroi de séparation divisant l'espace du boîtier (9) en une partie de connexion et une partie détecteur située derrière la paroi de séparation (11) vue en direction du côté de connexion (90), et
- la paroi de séparation (11) présentant une fente (110),
- la carte de circuit imprimé (3) étant insérée et fixée dans le boîtier (9) de telle sorte que sa partie d'équipement (37) est disposée dans la partie détecteur (15) du boîtier (9) et sa partie de connexion (35) et les pistes de connexion (38) se trouvant sur celle-ci entrent dans la partie de connexion du boîtier (9) à travers la fente (110), et
- un élément de connexion électrique (25) étant fixé sur le côté de connexion (90) et étant raccordé électriquement aux pistes de connexion (38) sur la partie de contact (35), et
- la partie détecteur du boîtier (9) étant rendue hermétique sur la paroi de séparation (11) au moyen d'une garniture, la partie de connexion de la carte de circuit imprimé (3) dépassant de la garniture.

8. Détecteur (1) encapsulé de manière hermétique selon la revendication précédente, **caractérisé par** une garniture hermétique sur la fente (110) dans la paroi de séparation (11).

9. Détecteur (1) encapsulé de manière hermétique selon l'une des deux revendications précédentes, **caractérisé en ce que** la garniture est réalisée avec un scellement en plastique (22) ou un enrobage de plastique.

10. Détecteur (1) encapsulé de manière hermétique selon l'une des trois revendications précédentes, **caractérisé en ce qu'**un câble ou un connecteur électrique est raccordé aux pistes de connexion (38) de la partie de contact (35) de la carte de circuit imprimé (3) et fixé au boîtier (9).

11. Détecteur (1) encapsulé de manière hermétique selon l'une des quatre revendications précédentes, **caractérisé en ce que** l'élément de connexion électrique est fixé au moyen d'un élément moulé en plastique sur la partie de connexion du boîtier (3).

12. Détecteur (1) encapsulé de manière hermétique selon l'une des cinq revendications précédentes, **caractérisé en ce que** deux garnitures hermétiques sont prévues, parmi lesquelles une garniture sur la paroi de séparation représentant une fermeture hermétique de la partie détecteur (15) par rapport à la partie de connexion (13) du boîtier et une seconde garniture représentant une fermeture hermétique de la partie de connexion (13) par rapport à l'environnement.

13. Détecteur (1) encapsulé de manière hermétique selon l'une des six revendications précédentes, dans lequel l'élément de connexion électrique comprend un connecteur électrique.

14. Détecteur (1) encapsulé de manière hermétique selon la revendication précédente, dans lequel un élément moulé est inséré dans la partie de connexion (13) du boîtier (9), lequel forme un logement (54) pour un connecteur électrique, et dans lequel un connecteur électrique est inséré dans le logement (54), les contacts de connexion électriques (52) du connecteur entrant en contact avec les pistes de connexion (38) sur la partie de contact (35) de la carte de circuit imprimé (3) faisant saillie de la paroi de séparation (11).
